# EUROPÄISCHE PATENTANMELDUNG

(11) **EP 0 802 708 A1**
(43) Veröffentlichungstag der Anmeldung: **22.10.1997**
(21) Anmeldenummer: 96302735.4
(22) Anmeldetag: 19.04.1996
(51) Int. Cl.: H05K 7/18, H02B 1/01

(54) **Gestellrahmen für Baugruppenträger**

(71) Anmelder: RITTAL-CSM Limited, Roborough, Plymouth PL6 7EZ (GB)
(72) Erfinder: Woodward Michael,, Looe (GB); Hobbs Stephen,, Plymouth (GB)
(74) Vertreter: Fleck, Hermann-Josef, Dr.-Ing.

(57) **Zusammenfassung**

Die Erfindung betrifft einen Gestellrahmen mit vier vertikalen, auf einem Sockel befestigten Rahmenschenkel, die zumindest auf den beiden Seiten mittels horizontaler Tiefenstreben miteinander verbunden sind und ein zur Vorder- und/oder Rückseite hin offenes Basis-Rahmengestell bilden, in das Baugruppenträger mit Frontplatten einsetzbar und darin festlegbar sind. Eine erhöhte Verwindungssteifigkeit und Erdbebensicherheit wird dadurch erreicht, daß auf beiden Seiten des Basis-Rahmengestelles auf den einander zugekehrten Innenseiten über die Höhe des Gestellrahmens reichende Seitenelemente angeordnet sind, deren vertikale Seiten gegeneinander gerichtete Befestigungsflansche für die Frontplatten der Baugruppenträger aufweisen, im unteren Bereich mit dem Sockel und in vertikaler Richtung mit den horizontalen Tiefenstreben kraft- und formschlüssig verbunden sind.

## Beschreibung

Die Erfindung betrifft einen Gestellrahmen mit vier vertikalen, auf einem Sockel befestigten Rahmenschenkel, die zumindest auf den beiden Seiten mittels horizontaler Tiefenstreben miteinander verbunden sind und ein zur Vorder- und/oder Rückseite hin offenes Basis-Rahmengestell bilden, in das Baugruppenträger mit Frontplatten einsetzbar und darin festlegbar sind.

Bei den bekannten Gestellrahmen dieser Art wird insbesondere bei Teilbestückung mit Baugruppenträger nicht immer eine ausreichende Verwindungssteifigkeit erreicht. Dies ist gerade beim Einsatz des Gestellrahmens in erdbebengefährdeten Gebieten mit der Gefahr verbunden, daß bei Erschütterungen der Gestellrahmen verschoben oder verzogen wird und diese Verformungen sich auf die eingebauten Baugruppenträger übertragen, was zu Teil- und Vollausfall der Funktionen führen kann.

Es ist Aufgabe der Erfindung, bei einem Gestellrahmen der eingangs erwähnten Art auf einfache Art die Verwindungssteifigkeit und damit die Erdbebensicherheit wesentlich zu erhöhen.

Diese Aufgabe wird nach der Erfindung dadurch gelöst, daß auf beiden Seiten des Basis-Rahmengestelles auf den einander zugekehrten Innenseiten über die Höhe des Gestellrahmens reichende Seitenelemente angeordnet sind, deren vertikale Seiten gegeneinander gerichtete Befestigungsflansche für die Frontplatten der Baugruppenträger aufweisen, im unteren Bereich mit dem Sockel und in vertikaler Richtung mit den horizontalen Tiefenstreben kraft- und formschlüssig verbunden sind.

Bei diesem Aufbau bilden die Seitenelemente mit dem Sockel und den horizontalen Tiefenstreben eine Art in das Basis-Rahmengestell eingebautes Einbau-Rahmengestell, das nicht mehr starr mit dem Basis-Rahmengestell verbunden ist, so daß sich Verformungen desselben nicht mehr auf das Einbau-Rahmengestell und die an diesem befestigten Baugruppenträger auswirken können.

Nach einer bevorzugten Ausgestaltung ist vorgesehen, daß die Befestigungsflansche an den Seitenelementen einstückig abgebogen sind und daß die Seitenelemente plattenförmig ausgebildet sind und jeweils bis in den Bereich der der zugeordneten Seite des Basis-Rahmengestelles zugekehrten Rahmenschenkel reichen und in einem Absatz auf deren Innenseiten anliegen.

Ist dazu vorgesehen, daß die Seitenelemente mit Durchbrüchen versehen sind, dann wird trotz Einbau der Seitenelemente der Zugang zu den Einbauten über die beiden Seiten des Basis-Rahmengestelles nicht unnötig erschwert.

Die Seitenelemente bilden mit dem Sockel und den horizontalen Tiefenstreben ein Einbau-Rahmengestell, das nach dem Anbringen der Frontplatten der eingebauten Baugruppenträger an den Befestigungsflanschen der Seitenelemente noch versteift und verstärkt wird.

Ist nach einer Ausgestaltung vorgesehen, daß die horizontalen Tiefenstreben an den vertikalen Rahmenschenkeln des Basis-Rahmengestelles nur gehalten, jedoch nicht kraft- und formschlüssig miteinander verbunden, z.B. lose verschraubt oder formschlüssig ineinander gehalten sind, dann wird über diese Verbindungsstellen nur eine Haltefunktion ausgeübt, eine direkte und ungedämpfte Weiterleitung von Schwingungen ist dabei jedoch nicht möglich, so daß das Basis-Rahmengestell und das Einbau-Rahmengestell schwingungstechnisch praktisch entkoppelt sind.

Das Rahmengestell kann nach weiteren Ausgestaltungen dadurch vervollständigt werden, daß die offene Vorder- (und)/oder Rückseite des Basis-Rahmengestelles mittels einer Tür mit einer durchsichtigen Scheibe verschließbar (sind) ist und daß die Seiten des Basis-Rahmengestelles mittels Wandelementen verschließbar sind, die mit den Außenseiten der zugekehrten vertikalen Rahmenschenkel verbindbar sind.

Die Verwindungssteifigkeit des Einbau-Rahmengestelles wird dadurch erhöht, daß die mit einem Durchbruch versehenen Seitenelemente selbst als starre Rahmen ausgebildet sind.

Die Erfindung wird anhand eines in den Zeichnungen dargestellten Ausführungsbeispiels näher erläutert. Es zeigt:
- Fig. 1: eine Ansicht auf die Außenseite einer Gestellrahmenseite mit eingebautem Seitenelement (in Richtung I der Fig. 2 gesehen) und
- Fig. 2: einen horizontalen Querschnitt durch den Gestellrahmen entlang der Linie II-II der Fig. 1,

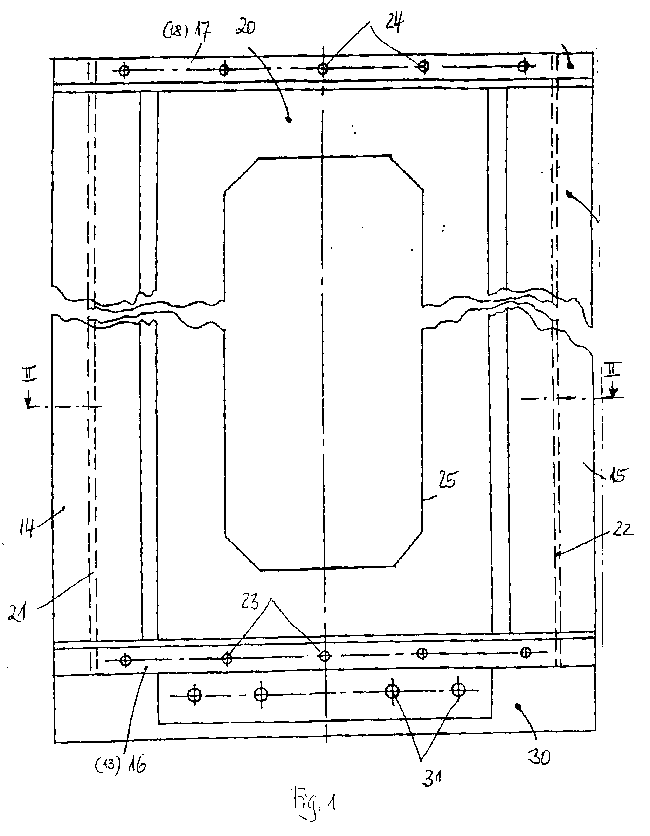

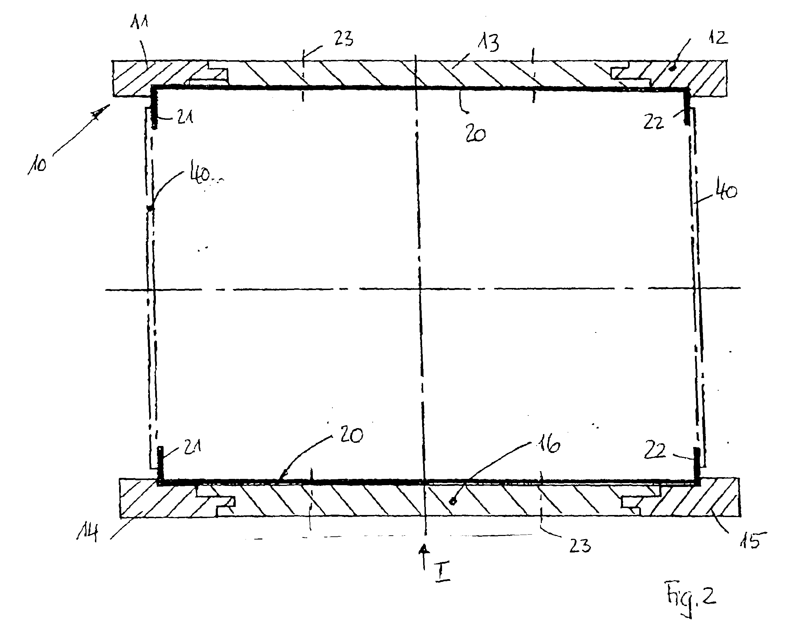

Wie die Fig. 1 und 2 erkennen lassen, sind vier vertikale Rahmenschenkel 11,12, 14 und 15 auf einem Sockel 30 befestigt und bilden ein Basis-Rahmengestell 10 mit rechteckförmigem Querschnitt. Auf den beiden Seiten des Basis-Rahmengestelles 10 sind die Rahmenschenkel 11 und 12 bzw. 14 und 15 paarweise über horizontale Tiefenstreben 13 und 18 bzw. 16 und 17 miteinander verbunden, so daß der Gestellrahmen auf seiner Vorder- und Rückseite offen für die Aufnahme von mit Frontplatten 40 versehenen Baugruppenträgern ist. Die Tiefenstreban 13 und 16 liegen im unteren Bereich und die Tiefenstreben 17 und 18 im oberen Bereich des Gestellrahmens und sind mit den Rahmenschenkeln 11, 12,14 und 15 nur gehalten, jedoch nicht kraft- und formschlüssig miteinander verbunden, z.B. lose miteinander verschraubt oder formschlüssig ineinander gehalten. Auf diese Weise bilden diese Verbindungsstellen eine Art schwingungstechnische Entkoppelung zwischen dem Basis-Rahmengestell 10 und dem aus den horizontalen Tiefenstreben 13,16,17 und 18 und von zwei daran kraft- und formschlüssig angebrachten Seitenelementen 20.

Diese Seitenelemente 20 sind auf den einander zugekehrten und senkrecht zur offenen Vorder- und Rückseite des Gestellrahmens stehenden Innenseiten des Basis-Rahmengestelles 10 angeordnet. Die Verbindungen sind als Schraubverbindungen 23 und 24 gezeichnet, die jedoch so festgezogen sind, daß ein kraft- und formschlüssiger Übergang von den Tiefenstreben 13,16, 17 und 18 und den Seitenelementen 20 erreicht wird. Wie aus Fig. 1 zu entnehmen ist, ragen die Seitenelemente 20 nach unten über die unteren horizontalen Tiefenstreben 13 und 16 hinaus und sind über Verbindungen 31 zusätzlich mit dem Sockel 30 verbunden.

Die Seitenelemente 20 sind plattenförmig und mit einem Durchbruch 25 versehen selbst als Rahmen ausgebildet. Ihre vertikalen Seiten sind als Befestigungsflansche 21 und 22 gegeneinander gerichtet. Die Befestigungsflansche 21 und 22 sind einstückig an den Seitenelementen 20 abgebogen und ragen in die offene Vorder- und Rückseite des Gestellrahmens, wie Fig. 2 zeigt. Die Seitenelemente 20 mit den abgebogenen Befestigungsflanschen 21 und 22 liegen in einem innenliegenden Absatz der vertikalen Rahmenschenkel 11,12 bzw. 14,15 an und überdecken diese Rahmenschenkel zumindest teilweise in ihrer Breite.

Sind Baugruppenträger eingebaut und mit ihren Frontplatten 40 an den Befestigungsflanschen 21 und 22 befestigt, dann wird das aus dem Sockel 30 und den beiden Seitenelementen 20 gebildete Einbau-Rahmengestell zusätzlich versteift und in der Verwindungssteifigkeit erhöht. Dies wirkt sich in Verbindung mit der Wahl der Verbindungsstellen zwischen dem Basis-Rahmengestell 10 und dem Einbau-Rahmengestell sowie den Schraubverbindungen 23,24 und 31 in einer erhöhten Erdbebensicherheit aus.

Die Seitenelemente 20 können zudem auf den einander zugekehrten Innenseiten als Befestigungsflächen für Tragschienen, Teleskopschienen und dgl. der Baugruppenträger ausgebildet oder verwendet sein.

## Patentansprüche

1. Gestellrahmen mit vier vertikalen, auf einem Sockel befestigten Rahmenschenkel, die zumindest auf den beiden Seiten mittels horizontaler Tiefenstreben miteinander verbunden sind und ein zur Vorder- und/oder Rückseite hin offenes Basis-Rahmengestell bilden, in das Baugruppenträger mit Frontplatten einsetzbar und darin festlegbar sind,
dadurch gekennzeichnet,
daß auf beiden Seiten des Basis-Rahmengestelles (10) auf den einander zugekehrten Innenseiten über die Höhe des Gestellrahmens reichende Seitenelemente (20) angeordnet sind, deren vertikale Seiten gegeneinander gerichtete Befestigungsflansche (21,22) für die Frontplatten (40) der Baugruppenträger aufweisen, im unteren Bereich mit dem Sockel (30) und in vertikaler Richtung mit den horizontalen Tiefenstreben (13,18; 16,17) kraft- und formschlüssig verbunden sind.

2. Gestellrahmen nach Anspruch 1,
dadurch gekennzeichnet,
daß die Befestigungsflansche (21,22) an den Seitenelementen (20) einstückig abgebogen sind.

3. Gestellrahmen nach Anspruch 1 oder 2,
dadurch gekennzeichnet,
daß die Seitenelemente (20) plattenförmig ausgebildet sind und jeweils bis in den Bereich der der zugeordneten Seite des Basis-Rahmengestelles (10) zugekehrten Rahmenschenkel (11, 12; 14,15) reichen und in einem Absatz auf deren Innenseiten anliegen.

4. Gestellrahmen nach einem der Ansprüche 1 bis 3,
dadurch gekennzeichnet,
daß die Seitenelemente (20) mit Durchbrüchen (25) versehen sind.

5. Gestellrahmen nach einem der Ansprüche 1 bis 4,
dadurch gekennzeichnet,
daß die Seitenelemente (20) mit dem Sockel (20) und den horizontalen Tiefenstreben (13,16,17,18) ein in das Basis-Rahmengestell (10) eingebautes, starres Einbau-Rahmengestell bilden.

6. Gestellrahmen nach einem der Ansprüche 1 bis 5,
dadurch gekennzeichnet,
daß die horizontalen Tiefenstreben (13,16,17,18) an den vertikalen Rahmenschenkeln (11,12,14,15) des Basis-Rahmengestelles (10) nur gehalten, jedoch nicht kraft- und formschlüssig miteinander verbunden, z.B. lose verschraubt oder formschlüssig ineinander gehalten sind.

7. Gestellrahmen nach einem der Ansprüche 1 bis 6,
dadurch gekennzeichnet,
daß die offene Vorder- (und/oder Rückseite des Basis-Rahmengestelles (10) mittels einer Tür mit einer durchsichtigen Scheibe verschließbar (sind) ist.

8. Gestellrahmen nach einem der Ansprüche 1 bis 7,
dadurch gekennzeichnet,
daß die Seiten des Basis-Rahmengestelles (10) mittels Wandelementen verschließbar sind, die mit den Außenseiten der zugekehrten vertikalen Rahmenschenkel (11,12; 13,14) verbindbar sind.

9. Gestellrahmen nach einem der Ansprüche 1 bis 8,
dadurch gekennzeichnet,
daß die mit einem Durchbruch (25) versehenen Seitenelemente (20) selbst als starre Rahmen ausgebildet sind.

10. Gestellrahmen nach einem der Ansprüche 1 bis 9,
dadurch gekennzeichnet,
daß auf den einander zugekehrten Innenseiten der Seitenelemente (20) Tragschienen, Teleskopschienen oder dgl. für die Baugruppenträger befestigbar oder befestigt sind.
